# EUROPEAN PATENT APPLICATION

(11) **EP 3 748 696 A1**
(43) Date of publication of application: **09.12.2020**
(21) Application number: 18769577.0
(22) Date of filing: 11.06.2018
(51) Int. Cl.: H01L 31/0465, H01L 31/0224

(54) **THIN FILM SOLAR CELL**

(30) Priority: 01.02.2018 CN 201810102076
(71) Applicant: Beijing Apollo Ding Rong Solar Technology Co., Ltd., Beijing 100176 (CN)
(72) Inventor: ZHAO, Shuli, Beijing 100176 (CN); GUO, Lida, Beijing 100176 (CN); LI, Xinlian, Beijing 100176 (CN); CHEN, Tao, Beijing 100176 (CN); YANG, Lihong, Beijing 100176 (CN)
(74) Representative: Cohausz & Florack
(86) International application number: PCT/CN2018/090710
(87) International publication number: WO 2019/148733

(57) **Abstract**

A thin film solar cell, including a substrate and a plurality of cell units disposed on the substrate, each cell unit includes a back electrode layer, a light absorbing layer, a buffer layer, and an upper electrode layer which are sequentially disposed. A first groove throughout the back electrode layer is disposed between the back electrode layers of any two adjacent cell units; the first groove is filled with an insulating portion. A second groove throughout the light absorbing layer and the buffer layer is disposed in each cell unit, the upper electrode layer of this cell unit extends to the second groove of this cell unit to contact the back electrode layer of the other cell unit of the two adjacent cell units. A third groove is disposed between the two adjacent cell units, the third groove insulate the upper electrode layers of the two adjacent cell units.

## Description

### CROSS-REFERENCE TO RELATED APPLICATION

This application claims priority to Chinese Patent Application No.201810102076.3, filed on February 01, 2018, titled "THIN FILM SOLARY CELL MODULE", which is incorporated herein by reference in its entirety.

### TECHNICAL FIELD

The present disclosure relates to a solar cell technical field, and in particular, to a thin film solar cell.

### BACKGROUND

The solar thin film cell is also called 'solar chip' or 'photovoltaic cell', which is a kind of optoelectronic semiconductor component using sunlight to generate electricity directly.

One step in the preparation process of the thin film solar cell is to use at least 3 laser/mechanical scribing processes (according to the chronological order of the scribing, it is named that P1 scribing, P2 scribing, and P3 scribing), to divide the whole thin film solar cell into a plurality of cell units, and series connection or parallel connection is realized among the plurality of cell units.

### SUMMARY

Several embodiments of the present disclosure provides a thin film solar cell, comprising a substrate and a plurality of cell units disposed on the substrate, each cell unit among the plurality of cell units comprises a back electrode layer, a light absorbing layer, a buffer layer, and an upper electrode layer which are sequentially disposed, wherein, a first groove throughout the back electrode layer is disposed between the back electrode layers of any two adjacent cell units among the plurality of cell units, the first groove is filled with an insulating portion, so as to insulate the back electrode layers of the two adjacent cell units, a second groove throughout the light absorbing layer and the buffer layer is disposed in each cell unit among the plurality of cell units, the upper electrode layer of any one cell unit of the two adjacent cell units covers the buffer layer of this cell unit and extends to the second groove of this cell unit to contact the back electrode layer of the other cell unit in the two adjacent cell units, and then which connects the two adjacent cell units in series, a third groove is disposed between the two adjacent cell units, the third groove insulates the upper electrode layers of the two adjacent cell units.

Several embodiments of the present disclosure further provides a method for preparing the thin film solar cell, comprising: forming a back electrode layer on the substrate; forming a first groove on the back electrode layer by performing the first scribing process; forming an insulating portion located in the first groove; sequentially forming a light absorbing layer and a buffer layer on the surface of the back electrode layer which is formed with the insulating portion, and performing a second scribing process to the light absorbing layer and the buffer layer to form a second groove throughout the light absorbing layer and the buffer layer; forming an upper electrode layer on the surface of the buffer layer, and extending the upper electrode layer to the second groove, so that the upper electrode layer of any one cell unit of the two adjacent cell units contacts the back electrode layer of the other adjacent cell unit in the two adjacent cell units; performing a third scribing process to the upper electrode layer, the buffer layer, and the light absorbing layer to form a third groove throughout the upper electrode layer, the buffer layer, and the light absorbing layer.

### BRIEF DESCRIPTION OF THE DRAWINGS

The accompanying drawings here are used to provide further understanding of the present disclosure and constitute a part of the present disclosure. The schematic embodiments of the present disclosure and the illustrations thereof serve to explain the present disclosure, but do not constitute an improper limitation to the disclosure. In the accompanying drawings,
Fig. 1 is the schematic diagram of the structure of the thin film solar cell according to the present disclosure;
Fig. 2 is the schematic diagram of the preparation process of the thin film solar cell according to the present disclosure.

### DETAILED DESCRIPTION

The technical solutions in the embodiments of the present disclosure will be described clearly and completely. Obviously, the described embodiments are merely some but not all of embodiments of the present disclosure. All other embodiments made on the basis of the embodiments of the present disclosure by a person of ordinary skill in the art without paying any creative effort shall be included in the protection scope of the present disclosure.

Although the P1, P2, and P3 scribing processes may form a plurality of series/parallel-connected cell units, at the same time, an area (spacer region between the positions of P1-P3 scribing lines and the adjacent scribing lines) incapable of photoelectric conversion may be generated in the thin film solar cell, i.e. so-called 'dead zone' in the thin film solar cell.

P1, P2, and P3 scribing processes are realized by laser or mechanical scribing, limited by the prior scribing process technological level and cost control factors, the width and accuracy of the P1∼P3 scribing lines are difficult to be improved, causing the area of dead zone cannot be effectively reduced, ultimately affecting the light conversion efficiency of the thin film solar cell.

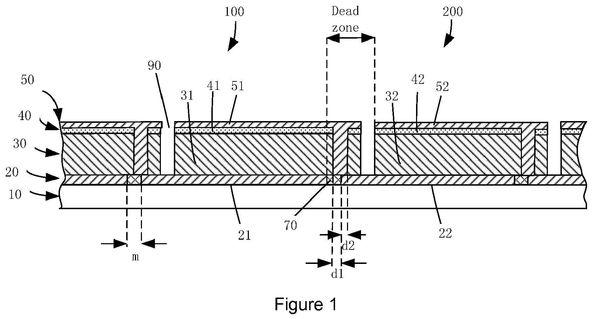

Referring to Fig. 1, several embodiments of the present disclosure provides a thin film solar cell. The thin film solar cell comprises a substrate 10 and a plurality of cell units disposed on the substrate 10. Each cell unit among the plurality of cell units comprises a back electrode layer 20, a light absorbing layer 30, a buffer layer 40, and an upper electrode layer 50 which are sequentially disposed. A first groove 60 throughout the back electrode layer 20 is disposed between the back electrode layers 20 of the two adjacent cell units. The first groove 60 is filled with an insulating portion 70, so as to insulate the back electrode layers 20 of the two adjacent cell units. A second groove 80 throughout the light absorbing layer 30 and the buffer layer 40 is disposed in each cell unit. The upper electrode layer 50 covers the buffer layer 40 and extends to the second groove 80 to contact the back electrode layer 20 of the other cell unit, and then connecting the other adjacent cell unit in series. A third groove 90 is disposed between the two adjacent cell units; the third groove 90 insulates the upper electrode layers 50 of the two adjacent cell units.

The thin film solar cell has the following advantage: since the insulating portion is set in the first groove, that is the back electrode layers among the plurality of cell units are disposed at interval via the insulating portion, so that the second groove may be formed on partial surface of the insulating portion, the insulating portion may be partly exposed by the second groove, the space between the position of the second groove and the position of the groove is reduced, and thus, the area of the dead zone is greatly reduced, thereby the conversion efficiency of the thin film solar cell is greatly improved.

In several embodiments of the present disclosure, the insulating portion is disposed on the position of the first scribing line (i.e. P1 scribing) of the thin film solar cell, i.e. back electrode layers among the plurality of cell units are disposed at interval via the insulating portion, thereby the second scribing (i.e. P2 scribing) can be performed on partial surface of the insulating portion, so as to reduce the area of the dead zone.

In the corresponding preparation method of the thin film solar cell, the first groove may be formed by the first scribing process, and the insulating portion is formed in the first groove by a mask, so that the second scribing may be performed on partial surface of the insulating portion. The interval between the position of the first scribing line and the position of the second scribing line is reduced, and thus, the area of the dead zone is greatly reduced. The method has the advantages of simple process, high efficiency and be easy to control.

As shown in Fig. 1, the following describes the structure of the thin film solar cell by taking the adjacent first cell unit 100 and second cell unit 200 in the thin film solar cell as an example.

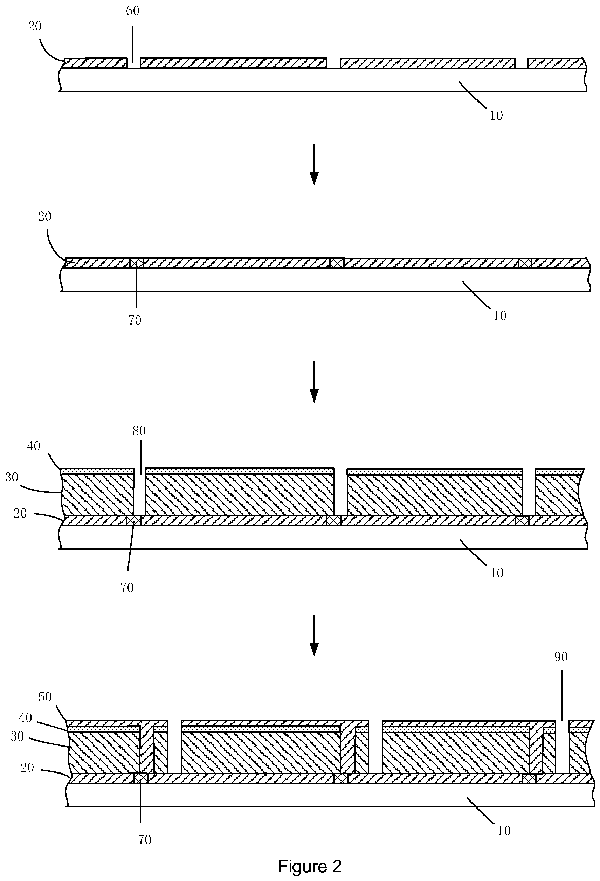

The first cell unit 100 is adjacent to and has the same structure with the second cell unit 200. That is, the first cell unit 100 and the second cell unit 200 are actually repeating cell units with the same structure, but are specifically named differently to better explain the relationship between the elements in the two adjacent battery units. The first cell unit 100 comprises a first back electrode layer 21, a first light absorbing layer 31, a first buffer layer 41, and a first upper electrode layer 51 which are sequentially disposed. The second cell unit 200 comprises a second back electrode layer 22, a second light absorbing layer 32, a second buffer layer 42, and a second upper electrode layer 52 which are sequentially disposed. The first cell unit 100 shares the substrate 10 with the second cell unit 200. The first back electrode layer 21 is separated from the second back electrode layer 22 by an insulating portion. Referring to Fig. 2, the first light absorbing layer 31 and the first buffer layer 41 have a second groove 80 throughout the first light absorbing layer 31 and the first buffer layer 41 along the thickness direction of the first light absorbing layer 31 and the first buffer layer 41. The first upper electrode layer 51 covers the first buffer layer 41 and extends to the second groove 80 to cover part of the second back electrode layer 22, so as to electrically connect with the second back electrode layer 22, i.e. the bottom of the second groove 80 exposes part of the second back electrode layer 22, the first upper electrode layer 51 extending to the bottom of this second groove 80 covers and contacts this part of the second back electrode layer 22, the first cell unit 100 is electrically connected with the second cell unit 200 to realize series connection.

In several embodiments of the present disclosure, the portion of the first upper electrode layer 51 extending to the second groove 80 covers the insulating portion 70, in several other embodiments of the present disclosure, the portion of the first upper electrode layer 51 extending to the second groove 80 does not cover the insulating portion 70. That is, in several embodiments of the disclosure, the second groove 80 may overlap with the first groove 60 formed by the first scribing (P1 scribing), or may not.

In several embodiments of the present disclosure, the bottom of the second groove 80 is located at the border of the insulating portion 70 and the back electrode layer of the other adjacent cell unit, the upper electrode layer located in the second groove 80 covers part of the insulating portion and part of the back electrode layer of the other adjacent cell unit. Referring to Fig. 1, in another words, the first upper electrode layer 51 covers the first buffer layer 41 and extends to the second groove 80 to cover part of the second back electrode layer 22 and part of the insulating portion 70. At this point, the width of the overlapping area between the portion of the first upper electrode layer 51 extending to the second groove 80 and the insulating portion 70 is represented as d1. The width of the insulating portion is represented as m. m and d1 satisfy the following conditions: m > d1 > 0. Wherein, the reason to define m > d1 is to avoid a short circuit caused by the contact of the portion of the first upper electrode layer 51 extending to the second groove 80 with the first back electrode layer 21. In some embodiments, m and d1 preferably satisfy the following conditions: m-d1 ≥ 30 µm, so as to avoid this kind of short circuit.

The insulating portion 70 is used to separate the first back electrode layer 21 from the second back electrode layer 22 to insulate them from each other, so as to realize the relative independence between the first cell unit 100 and the second cell unit 200. In several embodiments of the present disclosure, the width m of the insulating portion 70 satisfies the following conditions: 30 µm ≤ m ≤ 60 µm, so as to better achieve the insulation effect. In several embodiments of the present disclosure, the width m of the insulating portion 70 satisfies the following conditions: the width m is larger than or equal to approximately 30 µm, smaller than or equal to approximately 60 µm.

In several embodiments of the present disclosure, the first groove is filled with the insulating portion 70 by mask deposition.

In several embodiments of the present disclosure, the material of the insulating portion 70 comprises at least one of Si₃N₄, AlN, SiO₂, and Al₂O₃. For example, the material of the insulating portion 70 is Si₃N₄. In several other embodiments of the present disclosure, the material of the insulating portion 70 comprises at least several of Si₃N₄, AlN, SiO₂, and Al₂O₃. For example, the material of the insulating portion 70 is the composite film layer of Si₃N₄ and SiO₂.

The width of the second groove 80 can be any size. In several embodiments of the present disclosure, the width of the second groove 80 is 50 µm∼80 µm, which can better electrically connect with the electrode and reduce the size of the dead zone. In several embodiments of the present disclosure, the width of the second groove 80 is approximately 50 µm∼80 µm.

In several embodiments of the present disclosure, the first cell unit 100 is separated from the second cell unit 200 by the third groove 90. The third groove 90 separates the first upper electrode layer 51 from the second upper electrode layer 52, separates the first buffer layer 41 from the second buffer layer 42, and separates the first light absorbing layer 31 from the second light absorbing layer 32.

In several embodiments of the present disclosure, the width of the third groove 90 is 50 µm∼80 µm or, approximately 50 µm∼80 µm.

The third groove 90 cooperates with the insulating portion 70 to achieve the "relatively independent" between the first cell unit 100 and the second cell unit 200. The reason why it is "relatively independent" is that the first upper electrode layer 51 in the second groove 80 can realize the series connection between the first cell unit 100 and the second cell unit 200.

The material of the substrate 10 is not limited, which may be glass, stainless steel or flexible materials. The thickness of the substrate 10 is also not limited. The substrate 10 plays a role of bearing the solar cell.

The material of the back electrode layer 20 may be metal Mo, Ti, Cr, Cu or a transparent conductive layer. The transparent conductive layer comprises one or more of aluminum-doped zinc oxide (AZO), boron-doped zinc oxide (AZO), and indium-doped tin oxide (ITO). The thickness back electrode layer 20 is not limited. In several embodiments of the present disclosure, the thickness of the back electrode layer 20 is 200 nm∼80 nm. In several embodiments of the present disclosure, the thickness of the insulating portion 70 is the same as the thickness of the back electrode layer 20. In several embodiments of the present disclosure, the thickness of the insulating portion 70 may also be greater than the thickness of the back electrode layer 20, in order to effectively prevent forming a short circuit.

The material of the light absorb layer 30 is one of copper indium gallium selenide, copper indium selenide, and copper indium gallium sulfide. The thickness of the light absorbing layer 30 is not limited. In several embodiments of the present disclosure, the thickness of the light absorbing layer 30 is 0.5 µm∼3 µm.

The material of the buffer layer 40 is one of zinc sulfide, cadmium sulfide, and indium sulfide. The thickness of the buffer layer 40 is not limited. In several embodiments of the present disclosure, the thickness of the buffer layer 40 is 30 nm∼ 100 nm.

The material of the upper electrode layer 50 is one of transparent conductive layer AZO, BZO and ITO. The thickness of the upper electrode layer 50 is not limited. In several embodiments of the present disclosure, the thickness of the upper electrode layer 50 is 100 nm∼1 µm.

In several embodiments of the present disclosure, other functional layers are added between any two of the electrode layer, the light absorbing layer, the buffer layer, and the upper electrode layer, the examples of the functional layers are zinc oxide layers, and zinc magnesium oxide layers, etc., so that the layers are intimately coupled with each other, and light absorption and conversion are facilitated.

Referring to Fig. 2, the embodiment of the present disclosure further provides a method for preparing the thin film solar cell. The method comprises the following steps:
a) Providing a substrate 10, and forming a back electrode layer 20 on the substrate 10, and forming a plurality of first grooves 60 throughout the back electrode layer 20 on the back electrode layer 20 by the first scribing to the back electrode layer 20;
b) Forming an insulating portion 70 in the first groove 60; and
c) Sequentially forming a light absorbing layer 30 and a buffer layer 40 on the surface of the back electrode layer 20 which is formed with the insulating portion 70, and the light absorbing layer 30 and buffer layer 40 are second scribed to form a second groove throughout the light absorbing layer 30 and buffer layer 40; and
d) Forming an upper electrode layer 50 on the surface of the buffer layer 40, so that the upper electrode layer 50 extends to the second groove 80, and the third scribing is performed to the upper electrode layer 50, the buffer layer 40, and the light absorbing layer 30 to form a third groove 90 throughout the upper electrode layer 50, the buffer layer 40, and the light absorbing layer 30, and then a plurality of series-connected cell units are obtained.

In the step a), the method of forming the back electrode layer 20 may be chemical vapor deposition method, magnetron sputtering method, and atomic layer deposition method, etc. After the first scribing, the back electrode layer 20 may form a plurality of "sub-back electrode layers" which are similar to the first back electrode layer 21 and the second back electrode layer 22 and are separated apart from each other. The "sub-back electrode layer" is the first back electrode layer 21 and the second back electrode layer 22 as shown in Fig. 1. The second scribing and the third scribing in step c) and d) is to scribe to the light absorbing layer 30, buffer layer 40 and the upper electrode layer 50 to form relatively independent and series-connected cell units. The first cell unit 100 and the second cell unit 200 showed in Fig. 1 are the specially named for better illustrating the relationship between the elements in the two adjacent cell units. In practice, the structures of the first cell unit 100 and the second cell unit 200, and the corresponding elements thereof are the same.

Hereinafter, the description of the light absorbing layer 30 can refer to the above description of the first light absorbing layer 31 and the second light absorbing layer 32. The description of the buffer layer 40 can refer to the above description of the first buffer layer 41 and the second buffer layer 42. The description of the upper electrode layer 50 can refer to the above description of the first upper electrode layer 51 and the second upper electrode layer 52. It will not be described here.

In step b), a mask (not shown in figures) is provided, and an insulating portion 70 is formed in the first groove 60 via the mask. The method of forming the insulating portion 70 may be any one of the magnetron sputtering method, the spin coating method, the spray coating method or the chemical vapor deposition method. Wherein, the process of the spin coating method and the spray coating method is: a mixture is obtained by mixing insulating material and solvent such as alcohol, water, etc., then the mixture is spin-coated or spray-coated, the insulating portion 70 is obtained after drying. In several embodiments of the present disclosure, the insulating portion 70 is formed by magnetron sputtering method.

In step c), the second groove 80 is formed by the second scribing to the light absorbing layer 30 and the buffer layer 40. The second groove 80 formed by the second scribing may overlap with part of the first groove 60 formed by the first scribing; or may separate from the first groove 60, i.e. they are not overlapped. In several embodiments of the present disclosure, the second groove 80 overlaps with part of the first groove 60, i.e. partial surface of the insulating portion 70 is exposed by the second groove 80.

The width of the insulating portion 70 is represented as m. The width of the partly exposed region of the insulating portion 70 by the second groove 80 is represented as d1, in several embodiments of the present disclosure, the width m of the insulating portion 70 is larger than d1. Illustratively, m-d1 ≥ 30 µm.

In step a), step c) and step d), the first scribing, the second scribing, and the third scribing can be realized by mechanical scribing or laser scribing. In several embodiments of the present disclosure, the method of the first scribing is laser scribing; the second scribing and the third scribing is mechanical scribing. The widths of the opening of the first groove 60, the second groove 80 and the third groove 90 are not limited. In several embodiments of the present disclosure, the width of the second groove 80 and the width of the third groove 90 may be 60 µm∼80 µm. Illustratively, the interval between the second groove 80 and the third groove 90 is greater than or equal to 30 µm.

The thin film solar cell and the preparation method thereof have the following advantages:
Since the insulating portion 70 is disposed in the first groove 60 formed by the first scribing, that is, the back electrode layers among the plurality of cell units are disposed at interval by the insulating portion, and thus the second scribing can be performed on partial surface of the insulating portion 70. The second scribing forms the second groove 80, the insulating portion can be partly exposed by the second groove 80, the interval between the position of the second scribing and the position of the first scribing is reduced, thereby, the area of the dead zone is greatly reduced, so that the conversion efficiency of the thin film solar cell is greatly improved.

In this preparation method, the insulating portion 70 is formed in the first groove 60 by the mask, thus the second scribing may be performed on partial surface of the insulating portion 70. The method has the advantages of simple process, high efficiency and be easy to control.

Hereinafter, the thin film solar cell and the preparation method thereof will be further described by the following embodiments.

### Embodiment 1

The present embodiment 1 provides a thin film solar cell. The preparation method of the thin film solar cell follows as below:
a) Providing a substrate, and forming a back electrode layer on the substrate by magnetron sputtering method. A first scribing is performed on the back electrode layer, and a plurality of first grooves throughout the back electrode layer are formed on the back electrode layer.
   In several embodiments, the material of the substrate is glass, the back electrode layer is metal Mo layer, parameters in magnetron sputtering method are: argon is used as an air source, metal Mo is used as a target material, the degree of vacuum is 0.1 Pa to 0.7 Pa; the first scribing is laser scribing, the width of the first groove is approximately 60 µm.
b) Providing a mask, an insulating portion made of Si₃N₄ is formed in the first groove by magnetron sputtering method.
c) Sequentially forming a light absorbing layer and a buffer layer on the surface of the back electrode layer which is formed with the insulating portion, and the light absorbing layer and the buffer layer are secondly scribed to form a second groove throughout the light absorbing layer and the buffer layer, wherein the second scribing is mechanical scribing, the width of the second groove is approximately 50 µm. The width d1 of the area of the insulating portion partly exposed by the second groove is approximately 30 µm. The light absorbing layer is copper indium gallium selenide with a thickness of approximately 3 µm. The buffer layer is cadmium sulfide with a thickness of approximately 80 nm.
d) Forming an upper electrode layer on the surface of the buffer layer, so that the upper electrode layer extends to the second groove, and the third scribing is performed to the upper electrode layer, the buffer layer, and the light absorbing layer to form a third groove throughout the upper electrode layer, the buffer layer, and the light absorbing layer, and then a plurality of series-connected cell units are obtained. Wherein, the third scribing is mechanical scribing. The interval between the third groove and the second groove (i.e. referring to Fig. 1, the interval between the right edge of the second groove 80 and the left edge of the third groove 90) is 40 µm, the upper electrode layer is an AZO transparent conductive film having a thickness of about 800 nm, and the third groove has a width of approximately 60 µm.

The width from the first groove to the third groove in the obtained thin film solar cell (i.e. referring to Fig. 1, the width from the left edge of the first groove to the right edge of the third groove, the same applies below) is about 180 µm.

### Embodiment 2

The present embodiment 2 provides a thin film solar cell. The preparation method of the thin film solar cell follows as below:
a) Providing a substrate, and forming a back electrode layer on the substrate by magnetron sputtering method. A first scribing is performed on the back electrode layer, and a plurality of first grooves throughout the back electrode layer are formed on the back electrode layer.
   Wherein, the material of the substrate is glass, the back electrode layer is metal Mo layer, parameters in magnetron sputtering method are: argon is used as an air source, metal Mo is used as a target material, the degree of vacuum is 0.1 Pa to 0.7 Pa. The first scribing is laser scribing, the width of the first groove is approximately 50 µm.
b) Providing a mask, an insulating portion made of Si₃N₄ is formed in the first groove by magnetron sputtering method.
c) Sequentially forming a light absorbing layer and a buffer layer on the surface of the back electrode layer which is formed with the insulating portion, and the light absorbing layer and the buffer layer are secondly scribed to form a second groove throughout the light absorbing layer and the buffer layer. Wherein the second scribing is mechanical scribing, the width of the second groove is approximately 70 µm. The width d1 of the area of the insulating portion partly exposed by the second groove is approximately 15 µm. The light absorbing layer is copper indium gallium selenide with a thickness of approximately 3 µm. The buffer layer is cadmium sulfide with a thickness of approximately 80 nm.
d) Forming an upper electrode layer on the surface of the buffer layer, so that the upper electrode layer extends to the second groove, and the third scribing is performed to the upper electrode layer, the buffer layer, and the light absorbing layer to form a third groove throughout the upper electrode layer, the buffer layer, and the light absorbing layer, and then a plurality of series-connected cell units are obtained. Wherein, the third scribing is mechanical scribing. The interval between the third groove and the second groove is 40 µm. The upper electrode layer is an AZO transparent conductive film having a thickness of about 30 µm. The third groove has a width of approximately 70 µm.

The method of preparing the thin film solar cell in the embodiment 2 is substantially the same as that in the embodiment 1, the difference is the width d1 of the area of the insulating portion partly exposed by the second groove; and the widths of the first groove, the second groove and the third groove.

The width from the first groove to the third groove in the obtained thin film solar cell is approximately 215 µm.

### Embodiment 3

The present embodiment 3 provides a thin film solar cell. The preparation method of the thin film solar cell follows as below:
a) Providing a substrate, and forming a back electrode layer on the substrate by magnetron sputtering method. A first scribing is performed on the back electrode layer, and a plurality of first grooves throughout the back electrode layer are formed on the back electrode layer.
   Wherein, the material of the substrate is glass, the back electrode layer is metal Mo layer, parameters in magnetron sputtering method are: argon is used as an air source, metal Mo is used as a target material, the degree of vacuum is 0.1 Pa to 0.7 Pa. The first scribing is laser scribing, the width of the first groove is approximately 40 µm.
b) Providing a mask, an insulating portion made of Si₃N₄ is formed in the first groove by magnetron sputtering method.
c) Sequentially forming a light absorbing layer and a buffer layer on the surface of the back electrode layer which is formed with the insulating portion, and the light absorbing layer and the buffer layer are secondly scribed to form a second groove throughout the light absorbing layer and the buffer layer. Wherein, the second scribing is mechanical scribing. The width of the second groove is approximately 80 µm. The width d1 of the area of the insulating portion partly exposed by the second groove is approximately 5 µm. The light absorbing layer is copper indium gallium selenide with a thickness of approximately 3 µm. The buffer layer is cadmium sulfide with a thickness of approximately 80 nm.
d) Forming an upper electrode layer on the surface of the buffer layer, so that the upper electrode layer extends to the second groove, and the third scribing is performed to the upper electrode layer, the buffer layer, and the light absorbing layer to form a third groove throughout the upper electrode layer, the buffer layer, and the light absorbing layer, and then a plurality of series-connected cell units are obtained. Wherein, the third scribing is mechanical scribing. The interval between the third groove and the second groove is 40 µm. The upper electrode layer is an AZO transparent conductive film having a thickness of about 30 µm. The third groove has a width of approximately 80 µm.

The method of preparing the thin film solar cell in the embodiment 3 is substantially the same as that in the embodiment 1, the difference is the width d1 of the area of the insulating portion partly exposed by the second groove; and the widths of the first groove, the second groove and the third groove.

The width from the first groove to the third groove in the obtained thin film solar cell is approximately 235 µm.

### Embodiment 4

The present embodiment 4 provides a thin film solar cell. The preparation method of the thin film solar cell follows as below:
a) Providing a substrate, and forming a back electrode layer on the substrate by magnetron sputtering method. A first scribing is performed on the back electrode layer, and a plurality of first grooves throughout the back electrode layer are formed on the back electrode layer.
   Wherein, the material of the substrate is glass, the back electrode layer is metal Mo layer, parameters in magnetron sputtering method are: argon is used as an air source, metal Mo is used as a target material, the degree of vacuum is 0.1 Pa to 0.7 Pa. The first scribing is laser scribing, the width of the first groove is approximately 40 µm.
b) Providing a mask, an insulating portion made of Si₃N₄ is formed in the first groove by magnetron sputtering method.
c) Sequentially forming a light absorbing layer and a buffer layer on the surface of the back electrode layer which is formed with the insulating portion, and the light absorbing layer and the buffer layer are secondly scribed to form a second groove throughout the light absorbing layer and the buffer layer. Wherein, the second scribing is mechanical scribing. The width of the second groove is approximately 60 µm. The insulating portion is not exposed by the second groove (that is, the width d1 of the area of the insulating portion partly exposed by the second groove is 0). The interval between the second groove and the first groove is 10 µm. The light absorbing layer is copper indium gallium selenide with a thickness of approximately 3 µm, and the buffer layer is cadmium sulfide with a thickness of approximately 80 nm.
d) Forming an upper electrode layer on the surface of the buffer layer, so that the upper electrode layer extends to the second groove, and the third scribing is performed to the upper electrode layer, the buffer layer, and the light absorbing layer to form a third groove throughout the upper electrode layer, the buffer layer, and the light absorbing layer, and then a plurality of series-connected cell units are obtained, wherein the third scribing is mechanical scribing, the interval between the third groove and the second groove is 40 µm, the upper electrode layer is an AZO transparent conductive film having a thickness of about 30 µm, and the third groove has a width of about 60 µm.

The method of preparing the thin film solar cell in the embodiment 4 is substantially the same as that in the embodiment 1, the different is, the position of the first scribing is separated from the position of the second scribing, i.e. after the second scribing in step c), the insulating portion is not exposed by the second groove; and the width of the first groove.

The width from the first groove to the third groove in the obtained thin film solar cell is approximately 210 µm.

For better illustrating the excellent performance of the thin film solar cell of the present disclosure, a comparative embodiment is further provided.

### Comparative embodiment

The present comparative embodiment provides a thin film solar cell module. The preparation method of the thin film solar cell module follows as below:
a) Providing a substrate, and forming a back electrode layer on the substrate by magnetron sputtering method. A first scribing is performed on the back electrode layer, and a plurality of first grooves throughout the back electrode layer are formed on the back electrode layer.
   Wherein, the material of the substrate is glass, the back electrode layer is metal Mo layer, parameters in magnetron sputtering method are: argon is used as an air source, metal Mo as a target material, the degree of vacuum is 0.1 Pa to 0.7 Pa. The first scribing is laser scribing. The width of the first groove is approximately 60 µm.
b) Sequentially forming a light absorbing layer and a buffer layer on the surface of the back electrode layer which is formed with the first groove, and the light absorbing layer and the buffer layer are secondly scribed to form a second groove throughout the light absorbing layer and the buffer layer. Wherein the second scribing is mechanical scribing, the width of the second groove is approximately 60 µm. The interval between the second groove and the first groove is 40 µm. The light absorbing layer is copper indium gallium selenide with a thickness of approximately 3 µm, and the buffer layer is cadmium sulfide with a thickness of approximately 80 nm.
c) Forming an upper electrode layer on the surface of the buffer layer, so that the upper electrode layer extends to the second groove, and the third scribing is performed to the upper electrode layer, the buffer layer, and the light absorbing layer to form a third groove throughout the upper electrode layer, the buffer layer, and the light absorbing layer, and then a plurality of series-connected units are obtained. Wherein, the third scribing is mechanical scribing. The upper electrode layer is an AZO transparent conductive film having a thickness of approximately 800 nm, and the third groove has a width of approximately 60 µm. The interval between the third groove and the second groove is 40 µm.

The method of preparing the thin film solar cell in present comparative embodiment is substantially the same as that in the embodiment 4, the different is, there is no step of forming an insulating portion in the first groove, but to directly form a light absorbing layer on the back electrode layer, i.e. the first groove is filled with a light absorbing layer.

The width (which represent the width of the dead zone) from the first groove to the third groove in the obtained thin film solar cell is approximately 260 µm. It can be seen that compared with the embodiment 1, the area of the dead zone in the comparative embodiment is larger. It can be seen from the above embodiment 1 to embodiment 4, the area of the dead zone of the thin film solar cell may greatly reduced, thus, during the application, the photoelectric conversion efficiency of the thin film solar cell may be greatly improved.

The width of the three grooves described above may be adjusted according to the implementation process, which is not limited by the above size, and various technical features of the above described embodiments can be combined randomly, in order to describe concisely, all the possible combinations of each technical features in above embodiments are not described, however, as long as there is no contradiction in the combination of these technical features, it should be considered as the scope described in present description.

The above embodiments are merely illustrative several modes of execution of the present disclosure, the description is more specific and detailed, but it should not be understood as limiting the scope of the present disclosure. It should be noted that, for the person skilled in the art, several variations and improvements may be made without departing from the concept of the present disclosure, and these are all within the protection scope of the present disclosure. Therefore, the scope of protection of the present disclosure shall be subject to the appended claims.

## Claims

1. A thin film solar cell, comprising a substrate and a plurality of cell units disposed on the substrate, each cell unit among the plurality of cell units comprises a back electrode layer, a light absorbing layer, a buffer layer, and an upper electrode layer which are sequentially disposed, wherein,
a first groove throughout the back electrode layer is disposed between the back electrode layers of any two adjacent cell units among the plurality of the cell units; the first groove is filled with an insulating portion, so as to insulate the back electrode layers of the two adjacent cell units;
a second groove throughout the light absorbing layer and the buffer layer is disposed in each cell unit among the plurality of the cell units, the upper electrode layer of any one cell unit of the two adjacent cell units covers the buffer layer of this cell unit and extends to the second groove of this cell unit to contact the back electrode layer of the other cell unit of the two adjacent cell units, so as to connect the two adjacent cell units in series; and
a third groove is disposed between the two adjacent cell units, the third groove insulates the upper electrode layers of the two adjacent cell units.

2. The thin film solar cell according to Claim 1, wherein, the third groove penetrates and separates apart the upper electrode layers, the buffer layers, and the light absorbing layers of the two adjacent cell units.

3. The thin film solar cell according to Claim 1, wherein, the first groove is filled with the insulating portion by mask deposition.

4. The thin film solar cell according to Claim 1 or 3, wherein, the material of the insulating portion is at least one or more of Si₃N₄, AlN, SiO₂, and Al₂O₃.

5. The thin film solar cell according to Claim 1, wherein, the two adjacent cell units comprise a first cell unit and a second cell unit, the first groove between the first cell unit and the second cell unit is filled with a first insulating portion,
a second groove throughout the light absorbing layer and the buffer layer of the first cell unit is disposed in the first cell unit, part of the first insulating portion and part of the back electrode layer of the second cell unit are exposed from the bottom of the second groove of the first cell unit,
the upper electrode layer located in the second groove of the first cell unit covers part of the first insulating portion and part of the back electrode layer of the second cell unit.

6. The thin film solar cell according to Claim 5, wherein, the width of the overlapping area between the portion of the upper electrode of the first cell unit extending to the second groove of the first cell unit and the first insulating portion is defined as d1, the width of the first insulating portion is defined as m, m and d1 satisfy the following conditions: m > d1 > 0.

7. The thin film solar cell according to Claim 1, wherein, the thin film solar cell further comprises at least one zinc oxide layer, the zinc oxide layer is disposed between the back electrode layer and the light absorbing layer, the light absorbing layer and the buffer layer, or the buffer layer and the upper electrode layer.

8. The thin film solar cell according to Claim 1, wherein, the width of the second groove and the width of the third groove are both 50 µm ∼80 µm, or,
the width of the second groove and the width of the third groove are both approximately 50 µm∼80 µm.

9. The thin film solar cell according to Claim 1, wherein, the thickness of the insulating portion is equal to or greater than the thickness of the back electrode layer.

10. The thin film solar cell according to Claim 1, wherein, the material of the light absorbing layer is any one of copper indium gallium selenide, copper indium selenide, and copper indium gallium sulfide.

11. A method for preparing the thin film solar cell, comprising:
forming a back electrode layer on the substrate;
forming a first groove on the back electrode layer by the first scribing process;
forming an insulating portion located in the first groove;
sequentially forming a light absorbing layer and a buffer layer on the surface of the back electrode layer which is formed with the insulating portion, and performing a second scribing process to the light absorbing layer and the buffer layer to form a second groove throughout the light absorbing layer and the buffer layer,
forming an upper electrode layer on the surface of the buffer layer, and extending the upper electrode layer to the second groove, so that the upper electrode layer of any one cell unit of the two adjacent cell units contacts the back electrode layer of the other adjacent cell unit in the two adjacent cell units;
performing a third scribing process to the upper electrode layer, the buffer layer, and the light absorbing layer to form a third groove throughout the upper electrode layer, the buffer layer, and the light absorbing layer.

12. The method according to Claim 11, wherein, the second groove formed by the second scribing process overlaps with part of the first groove formed by the first scribing process.

13. The method according to Claim 11, wherein, the first scribing process is laser scribing; the second scribing process and the third scribing process are mechanical scribing.

14. The method according to Claim 11, wherein, the insulating portion is formed by any one of magnetron sputtering method, spin coating method, spray method or chemical vapor deposition method.

15. The method according to Claim 11, wherein, the insulating portion is formed in the first groove by mask deposition.
